(19) Europäisches Patentamt
European Patent Office
Office européen des brevets

(11)  **EP 1 906 515 A2**

(12)  **EUROPÄISCHE PATENTANMELDUNG**

(43) Veröffentlichungstag:
**02.04.2008 Patentblatt 2008/14**

(51) Int Cl.:
***H02M 1/12*** *(2006.01)*

(21) Anmeldenummer: **07113834.1**

(22) Anmeldetag: **06.08.2007**

| | |
|---|---|
| (84) Benannte Vertragsstaaten:<br>**AT BE BG CH CY CZ DE DK EE ES FI FR GB GR HU IE IS IT LI LT LU LV MC MT NL PL PT RO SE SI SK TR**<br>Benannte Erstreckungsstaaten:<br>**AL BA HR MK YU**<br><br>(30) Priorität: **27.09.2006 DE 102006045697** | (71) Anmelder: **SIEMENS AKTIENGESELLSCHAFT**<br>**80333 München (DE)**<br><br>(72) Erfinder:<br>• **Fuchs, Andreas Dr.**<br>  **91056 Erlangen (DE)**<br>• **Hoffmann, Wolfgang**<br>  **91052 Erlangen (DE)** |

(54)  **Verfahren zur Erzeugung von Bandsperren in elektrischen Filtern für Bahnfahrzeuge**

(57)  Die Erfindung betrifft ein Verfahren zur Erzeugung von Bandsperren in elektrischen Filtern.

Erfindungsgemäß wird

- in den Filterquerzweig eine Spannungsquelle mit variabler Spannung ($U_q$) eingesetzt,
- das an dem Ausgang des Filters (1) anliegende Ausgangssignal ($I_{netz}$) einer Regeleinrichtung (2) zugeführt,
- mit dem Ausgangssignal ($U_q$) der Regeleinrichtung (2) die Spannungsquelle angesteuert, und
- die Regeleinrichtung (2) nach dem Prinzip der repetitiven Regelung entworfen.

Vorzugsweise besteht die Regeleinrichtung (2) aus folgenden zwei Teilsystemen:

- Ein Teilsystem "Resonanzen" mit der Übertragungsfunktion

$$H_{res}(s) = \prod_{r=0}^{n-1} \frac{1}{s^2 + \omega_r^2} \ .$$

- ein Teilsystem "Stabilisierung", welches unter Einbeziehung der Filterparameter nach einem beliebigen Verfahren so zu entwerfen ist, dass die geregelte Strecke und die Regeleinrichtung (2) stabil und kausal sind.

FIG 4

EP 1 906 515 A2

**Beschreibung**

Die Erfindung betrifft ein Verfahren zur Erzeugung von Bandsperren in elektrischen Filtern für Bahnfahrzeuge.

Den Stand der Technik für aktive Filter für Gleichspannungsfahrzeuge beschreibt van der Weem, J. in "Aktive Filter für Gleichspannungsfahrzeuge", Elektrische Bahnen 92, 10/1994, wie folgt.

Schienenfahrzeuge des Nahverkehrs werden häufig aus einem Gleichspannungsnetz gespeist. Der Antrieb der modernen Fahrzeuge besteht aus Drehstromasynchronmaschinen und Wechselrichtern.

Bahnbetreiber setzen sehr niedrige Grenzwerte für die Anteile des Fahrleitungsstromes bei den Frequenzen, mit denen Gleisfreimelde- oder andere Signalanlagen arbeiten. Die Frequenz ist bei Gleichspannungsbahnen oft 50 Hz aus dem Landesnetz. Anteile mit dieser Frequenz im Fahrleitungsstrom entstehen bei allen Fahrzeugen unter normalen Betriebsbedingungen.

Bei stromeinprägenden Wechselrichtern wird der Zwischenkreisstrom mit einem Tiefsetzsteller eingestellt (Müller-Hellmann, A: Gleichstromsteller-Typen auf Fahrzeugen des schienengebundenen Nahverkehrs; Der Nahverkehr, 1983, H. 3).

Bei spannungseinprägenden Wechselrichtern speist ein Hochsetzsteller einen Gleichpannungszwischenkreis (Ferrazzini, P; Luca, S de; Gomisel, G; Piro, G: Die elektrische Ausrüstung der Lokomotivbaureihe E 402 der italienischen Staatsbahnen; Elektrische Bahnen 89/1991, H. 4, S. 114-122). Spannungseinprägende Wechselrichter können aber auch ohne vorgeschalteten Steller direkt an der Fahrleitungsspannung betrieben werden (Bayer, M; Klein, K.-H.; Nerb, K.-H.: Eine neue Straßenbahngeneration für München-Prototypfahrzeuge der Baureihe R1.1; Elektrische Bahnen 89/1991, H. 6, S. 186-192).

Alle Fahrzeugtypen haben ein Eingangsfilter mit einer Kennfrequenz, die bei ungefähr 30 Hz liegt, und bei allen entstehen niederfrequente Anteile, beispielsweise 50 Hz, im Fahrleitungsstrom.

Diese niederfrequenten Anteile können die sicherheitsrelevante Funktion von Gleisfreimeldeanlagen stören.

Gleisfreimeldeanlagen erkennen, ob ein Gleisabschnitt von einem Fahrzeug besetzt ist oder nicht. Bei Gleichspannungsbahnen arbeiten sie häufig mit der Frequenz des Landesnetzes, also meistens mit 50 Hz.

Um einen sicheren Betrieb zu gewährleisten fordern die Bahnbetreiber von den Fahrzeugherstellern die Begrenzung von Strömen, die die Signalfrequenz aufweisen.

Die Grenzwerte liegen in der Größenordnung von 1 bis 2 A. Um sie einzuhalten, sind schon frühzeitig Verfahren entwickelt worden. So ist in dem Aufsatz Nill, G.R.; Daumann, W.: Three-Phase A.C. Motor Vehicles from D.C. Power Supply Feed-In Circuid and Interference Current Reduktion; 2nd IFAC Symp., Düsseldorf, 1977, S. 777-785, der Eingriff in die Regelung des Hochsetzstellers beschrieben.

Eine andere bekannte Möglichkeit besteht darin, die Schaltzeitpunkte des spannungseinprägenden Wechselrichters zu optimieren (Taufig, J.A.; Mellitt, B.; Goodman, C.J.: Novel algorithm for generating near optimal PMW waveforms for AC traction drives; IEE Proc. Pt. B 133 (1986), H. 2, S. 85-94). Damit kann eine bestimmte Anzahl von Oberschwingungen aus dem Eingangsstrom des Wechselrichters eliminiert werden, so dass es auch geringere Rückwirkungen auf das speisende Netz gibt.

In dem Aufsatz Cascone, V.; Galasso, M.; Mantica, L.;Oberti, M.: Design of Active Filters for Dynamic Damping of Harmonic Currents generated by Asyncronous Drivers in Modern High Power Locomotives; PESC, Zolrdo, Spanien, 1992, S. 404-410, ist ein aktives Filter vorgestellt, das an den Eingang des Fahrzeuges, also an die Fahrleitung, angeschlossen ist.

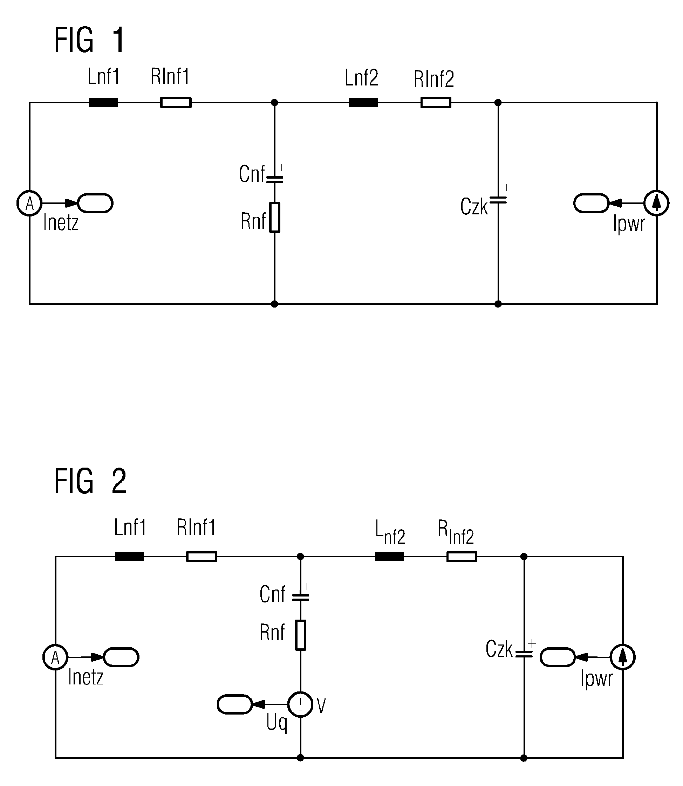

Fig.1 der vorliegenden Erfindungsbeschreibung zeigt das elektrische Ersatzschaltbild von in Bahnfahrzeugen verwendeten Filtern, mit denen ein Verhältnis von Netzstrom $I_{netz}$ zum Strom durch einen Pulswechselrichter $I_{pwr}$ für bestimmte Frequenzen betragsmäßig kleiner als Eins erreicht werden kann.

Im Einzelnen sollen für $n$ Frequenzen $\omega_r$ $\forall$ $0 \leq r \leq n\text{-}1$ die Forderungen $|H_0(j\omega_r)| < A_r$ mit

$$H_0(s) = \frac{I_{netz}(s)}{I_{pwr}(s)}$$ gelten. Dabei sind die $A_r$'s

reelle Werte größer Null, welche sich aus Vorschriften wie Störstromgrenzwerten ergeben.

Aufgrund von Rahmenbedingungen wie Bauelementgröße, -preis und -gewicht können diese Forderungen aber nicht immer eingehalten werden.

Es ist versucht worden, die Störstromgrenzwerte mittels Anpassung/Optimierung der Filter-Bauelemente einzuhalten. Dies ist nicht immer möglich. Bei aktiver Kompensation, wie in dem Aufsatz von van der Weem, J., Aktive Filter für Gleichspannungsfahrzeuge, Elektrische Bahnen 92, 10/1994, beschrieben, werden Stromquellen, die parallel zum Filterkondensator angebracht sind, verwendet.

Stand der Technik beim Reglerentwurf ist, analoge Reglerbausteine, wie PID-Regler, Bandpässe oder Mischer, zu kombinieren und die Reglerparameter manuell einzustellen.

Der Erfindung lag die Aufgabe zugrunde, ein Verfahren zu schaffen, durch welches die o.g. Vorschriften ohne Änderung der Filter-Bauelemente eingehalten werden können.

Die Aufgabe wird gemäß der Erfindung durch ein Verfahren mit den Merkmalen des Patentanspruches 1 gelöst.

Eine vorteilhafte Ausgestaltung ist durch die Merkmale des Unteranspruchs 2 gegeben.

Es wird der Vorteil erzielt, dass Störströme mit einfachen Mitteln unterdrückt werden können.

In den Filterquerzweig wird eine Spannungsquelle mit variabler Spannung $U_q$ eingesetzt.

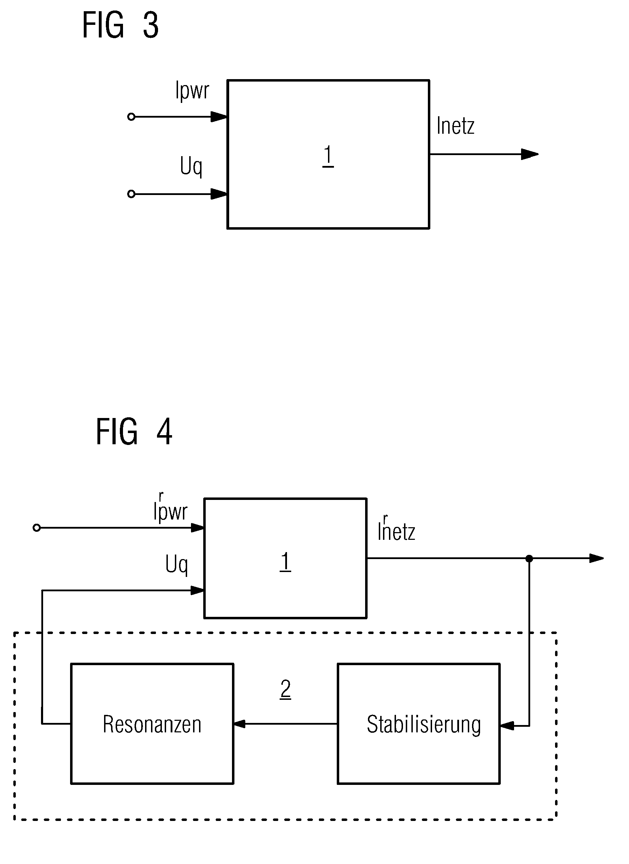

Das Filter hat jetzt zwei Eingänge und einen Ausgang, wie im Blockdiagramm in Fig. 3 dargestellt. Das Ausgangssignal $I_{netz}$ wird nun einer Regeleinrichtung 2 zugeführt. Deren Ausgangssignal liefert das Signal $U_q$, mit dem die Spannungsquelle angesteuert wird (Fig. 4).

Um die Forderungen an die Übertragung von PWR-Strom auf Netzstrom erfüllen zu können, wird erfindungsgemäß die Regeleinrichtung 2 nach dem Prinzip der repetitiven Regelung entworfen. Das Prinzip der repetitiven Regelung ist in dem Aufsatz J. Ghosh and B. Paden, Nonlinear repetitive control, IEEE Transactions on Automatic Control, Vol. 45(6), pp. 949-953, May 2000, beschrieben.

Dabei besteht die Regeleinrichtung 2 aus zwei Teilsystemen:

- Ein Teilsystem "Resonanzen" mit der Übertragungsfunktion $H_{res}(s) = \prod_{r=0}^{n-1} \dfrac{1}{s^2 + \omega_r^2}$ . Dadurch wird bei einem stabilen System im eingeschwungenen Zustand die Regelkreisverstärkung bei den Frequenzen $\omega_r$ unendlich groß,

- Ein Teilsystem "Stabilisierung", welches unter Einbeziehung der Filterparameter nach einem beliebigen Verfahren so zu entwerfen ist, dass die geregelte Strecke (Fig. 4) und die Regeleinrichtung 2 stabil und kausal sind.

Betrachtet man jetzt die Übertragungsfunktion

$$H_g(s) = \frac{I_{netz}^r(s)}{I_{pwr}^r(s)} \text{ , }$$

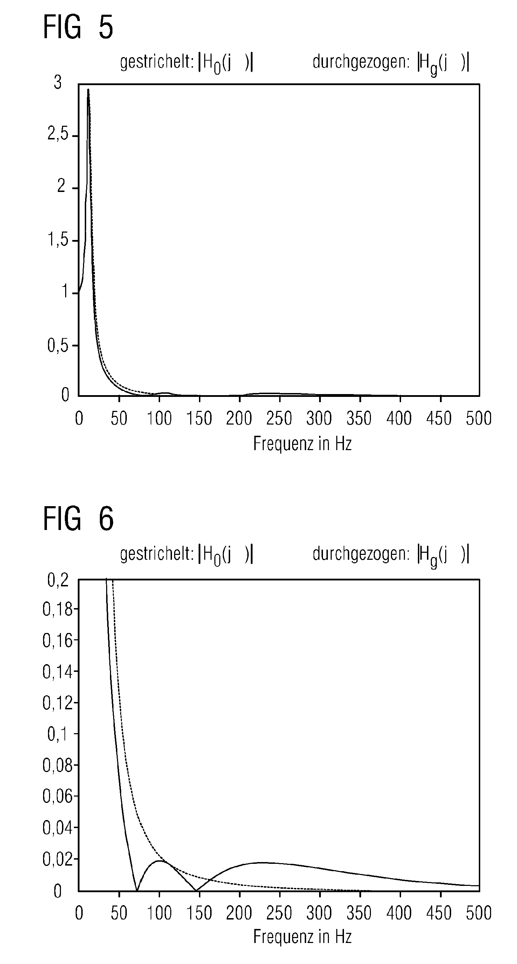

so gilt aufgrund des Terms $H_{res}(s)$ in der Rückführschleife $H_g(j\omega_r)|_{s=j\omega_r} = 0$ und damit natürlich auch $|H_g(j\omega_r)| < A_r$. Die Betragsverläufe von $H_g(j\omega_r)$ und $H_0(j\omega_r)$ sind beispielhaft für die Frequenzen $\omega_0 = 2\pi \cdot 75$ *rad* und $\omega_1 = 2\pi \cdot 150$ *rad* in Fig. 5 (Betragsfrequenz des offenen und geschlossenen Regelkreises) und Fig. 6 (Betragsfrequenz des offenen und geschlossenen Regelkreises, gezoomte Darstellung) dargestellt.

Durch Einfügen einer geregelten Spannungsquelle in den Kondensatorzweig des in Fig. 1 gezeigten Filters entsteht das in Fig. 2 gezeigte Filter 1, mit dem für bestimmte, frei wählbare Frequenzen eine (hohe) einstellbare Sperrfilterfunktion für diese Frequenzen erreicht wird. Dazu ist das beschriebene erfindungsgemäße Regelungsverfahren erforderlich.

Mit diesem kann insbesondere erreicht werden, dass die Störübertragung bei den gewählten Frequenzen exakt zu Null wird und die Regelstrecke stabil bleibt. Darüber hinaus liefert das systematische Verfahren automatisch die Reglerparameter, manuelle Einstellungen der Parameter sind nicht erforderlich.

Durch die Erfindung können somit Störströme zusätzlich unterdrückt werden, die mit den aus dem Stand der Technik bekannten Filtern nicht oder nur mit großem Aufwand (Gewicht, Kosten) unterdrückbar waren.

**Patentansprüche**

1. Verfahren zur Erzeugung von Bandsperren in elektrischen Filtern für Bahnfahrzeuge, **dadurch gekennzeichnet,**

    - **dass** in den Filterquerzweig eine Spannungsquelle mit variabler Spannung ($U_q$) eingesetzt wird,
    - **dass** das an dem Ausgang des Filters (1) anliegende Ausgangssignal ($I_{netz}$) einer Regeleinrichtung (2) zugeführt wird,
    - **dass** mit dem Ausgangssignal ($U_q$) der Regeleinrichtung (2) die Spannungsquelle angesteuert wird und
    - **dass** die Regeleinrichtung (2) nach dem Prinzip der repetitiven Regelung entworfen wird.

2. Verfahren nach Anspruch 1, **dadurch gekennzeichnet, dass** die Regeleinrichtung (2) aus folgenden zwei Teilsystemen besteht:

    - Ein Teilsystem "Resonanzen" mit der Übertragungsfunktion $H_{res}(s) = \prod_{r=0}^{n-1} \dfrac{1}{s^2 + \omega_r^2}$ .
    - ein Teilsystem "Stabilisierung", welches unter Einbeziehung der Filterparameter nach einem beliebigen Verfahren so zu entwerfen ist, dass die geregelte Strecke und die Regeleinrichtung (2) stabil und kausal sind.

## FIG 1

## FIG 2

## FIG 3

$Ipwr$

$Uq$

$\underline{1}$

$Inetz$

## FIG 4

$I^{r}pwr$

$Uq$

$\underline{1}$

$I^{r}netz$

$\underline{2}$

Resonanzen

Stabilisierung

# FIG 5

gestrichelt: $|H_0(j\omega)|$    durchgezogen: $|H_g(j\omega)|$

Frequenz in Hz

# FIG 6

gestrichelt: $|H_0(j\omega)|$    durchgezogen: $|H_g(j\omega)|$

Frequenz in Hz

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **VAN DER WEEM, J.** Aktive Filter für Gleichspannungsfahrzeuge. *Elektrische Bahnen,* Oktober 1994, vol. 92
- **MÜLLER-HELLMANN, A.** Gleichstromsteller-Typen auf Fahrzeugen des schienengebundenen Nahverkehrs. *Der Nahverkehr,* 1983, vol. H. 3
- **FERRAZZINI, P ; LUCA, S DE ; GOMISEL, G ; PIRO, G.** Die elektrische Ausrüstung der Lokomotivbaureihe E 402 der italienischen Staatsbahnen. *Elektrische Bahnen,* 1991, vol. H. 4, 114-122
- **BAYER, M ; KLEIN, K. ; NERB, K.-H.** Eine neue Straßenbahngeneration für München-Prototypfahrzeuge der Baureihe R1.1. *Elektrische Bahnen,* 1991, vol. 6, 186-192

- **NILL, G.R ; DAUMANN, W.** Three-Phase A.C. Motor Vehicles from D.C. Power Supply Feed-In Circuid and Interference Current Reduktion. *2nd IFAC Symp,* 1977, 777-785
- **TAUFIG, J.A ; MELLITT, B ; GOODMAN, C.J.** Novel algorithm for generating near optimal PMW waveforms for AC traction drives. *IEE Proc. Pt. B 133,* 1986, vol. 2, 85-94
- **CASCONE, V ; GALASSO, M ; MANTICA, L ; OBERTI, M.** Design of Active Filters for Dynamic Damping of Harmonic Currents generated by Asyncronous Drivers in Modern High Power Locomotives. *PESC,* 1992, 404-410
- **J. GHOSH ; B. PADEN.** Nonlinear repetitive control. *IEEE Transactions on Automatic Control,* Mai 2000, vol. 45 (6), 949-953